(19) Europäisches Patentamt

European Patent Office

Office européen des brevets

(11) **EP 1 117 001 B1**

(12) **EUROPÄISCHE PATENTSCHRIFT**

(45) Veröffentlichungstag und Bekanntmachung des Hinweises auf die Patenterteilung:
**09.06.2004 Patentblatt 2004/24**

(51) Int Cl.[7]: **G03F 1/14**

(21) Anmeldenummer: **00125692.4**

(22) Anmeldetag: **23.11.2000**

(54) **Lithographieverfahren und Maske zu dessen Durchführung**

Photolithographic process and mask therefor

Procédé photolithographique et masque pour sa réalisation

(84) Benannte Vertragsstaaten:
**DE FR GB IE IT**

(30) Priorität: **02.12.1999 DE 19958201**

(43) Veröffentlichungstag der Anmeldung:
**18.07.2001 Patentblatt 2001/29**

(73) Patentinhaber: **Infineon Technologies AG**
**81669 München (DE)**

(72) Erfinder:
• **Czech, Guenther**
**01465 Langebrück (DE)**
• **Friedrich, Christoph**
**80637 München (DE)**
• **Fuelber, Carsten, Dr.**
**01099 Dresden (DE)**
• **Kaesmaier, Rainer**
**85447 Fraunberg (DE)**
• **Widmann, Dietrich, Dr.**
**deceased (DE)**

(74) Vertreter: **Epping, Hermann, Fischer**
**Patentanwaltsgesellschaft mbH**
**Ridlerstrasse 55**
**80339 München (DE)**

(56) Entgegenhaltungen:
EP-A- 0 710 890        WO-A-87/07400
US-A- 4 890 309       US-A- 5 641 593
US-A- 6 150 060

• GWYN C W ET AL: "EXTREME ULTRAVIOLET LITHOGRAPHY" JOURNAL OF VACUUM SCIENCE AND TECHNOLOGY: PART B, AMERICAN INSTITUTE OF PHYSICS. NEW YORK, US, Bd. B16, Nr. 6, November 1998 (1998-11), Seiten 3142-3149, XP001023565 ISSN: 0734-211X
• TENNANT D M ET AL: "MASK TECHNOLOGIES FOR SOFT-X-RAY PROJECTION LITHOGRAPHY AT 13NM" APPLIED OPTICS, OPTICAL SOCIETY OF AMERICA,WASHINGTON, US, Bd. 32, Nr. 34, 1. Dezember 1993 (1993-12-01), Seiten 7007-7011, XP000770762 ISSN: 0003-6935
• TROUILLER Y ET AL: "0.12MUM OPTICAL LITHOGRAPHY PERFORMANCES USING AN ALTERNATING DEEP UV PHASE SHIFT MASK" JAPANESE JOURNAL OF APPLIED PHYSICS, PUBLICATION OFFICE JAPANESE JOURNAL OF APPLIED PHYSICS. TOKYO, JP, Bd. 37, Nr. 12B, Dezember 1998 (1998-12), Seiten 6714-6717, XP000880243 ISSN: 0021-4922
• LIN B J: "PHASE-SHIFTING MASKS GAIN AN EDGE" IEEE CIRCUITS AND DEVICES MAGAZINE, IEEE INC. NEW YORK, US, Bd. 9, Nr. 2, 1. März 1993 (1993-03-01), Seiten 28-35, XP000441752 ISSN: 8755-3996

**Beschreibung**

Die Erfindung betrifft ein Lithographieverfahren gemäß dem Oberbegriff des Anspruchs 1 sowie eine Maske zur Durchführung dieses Verfahrens gemäß dem Oberbegriff des Anspruchs 4.

Lithographieverfahren, die insbesondere auf Photolithographieprozessen basieren, werden zur Herstellung von integrierten Schaltungen, insbesondere zur Herstellung von Leitbahnen zur Verdrahtung von integrierten Schaltkreisen, eingesetzt.

Derartige Leitbahnen werden üblicherweise in Isolatorschichten eingearbeitet, welche unmittelbar oder unter Zwischenlagerung einer Metallschicht auf einem Substrat aufsitzen, welches die integrierten Schaltungen enthält. Derartige Substrate bestehen üblicherweise aus Siliziumschichten, während die Isolatorschichten aus Oxidschichten bestehen, vorzugsweise aus Siliziumoxiden.

Zur Herstellung der Leitbahnen in der Isolatorschicht werden in einer Ebene oder in mehreren Ebenen verlaufende Gräben und Kontaktlöcher eingearbeitet, wobei hierzu vorzugsweise Ätzprozesse insbesondere Plasma-Ätzprozesse eingesetzt werden.

Um diese Gräben und Kontaktlöcher in die Isolatorschicht einzuarbeiten wird eine Resistmaske mit einem den Gräben und/oder den Kontaktlöchern entsprechenden Lochmuster auf die Isolatorschicht aufgebracht. Üblicherweise werden auch in einem mehrstufigen Prozess nacheinander mehrere Resistmasken aufgebracht, um Kontaktlöcher und/oder Gräben in mehreren Ebenen der Isolatorschicht einzuarbeiten.

Durch die entsprechenden Öffnungen in den Resistmasken werden mit vorgegebenen Tiefen die einzelnen Gräben und Kontaktlöcher eingeätzt. Danach werden die Resistmasken von der Isolatorschicht entfernt. Schließlich wird zur Herstellung der Leitbahnen Metall in die Gräben und/oder Kontaktlöcher abgeschieden.

Die Herstellung von Resistmasken auf den Isolatorschichten erfolgt mittels bekannter Photolithographieprozesse. Dabei wird auf die Isolatorschicht zunächst eine strahlungsempfindliche Resistschicht aufgebracht. Durch Aufsetzen von Schablonen oder dergleichen wird diese Resistschicht an vorgegebenen Stellen mit Strahlung, insbesondere Lichtstrahlung beaufschlagt. Danach werden in einem geeigneten Entwickler entweder nur die belichteten oder nur die unbelichteten Bereiche der Resistschicht entfernt. Im ersten Fall liegt ein sogenannter Positiv-Resist, im zweiten Fall ein Negativ-Resist vor. Die Resistschicht mit dem so erzeugten Lochmuster bildet dann die Resistmaske für die nachfolgenden Ätzprozesse.

Bei dem Belichtungsprozess sollen die Strahlen, insbesondere Lichtstrahlen, entsprechend einem vorgegebenen Lochmuster möglichst genau auf die Oberfläche der Resistschicht abgebildet werden. Dabei soll eine möglichst hohe Auflösung erzielt werden, was gleichbedeutend damit ist, einen möglichst abrupten Übergang von belichteten und unbelichteten Stellen in der Photoresistschicht zu erhalten.

Die Belichtung erfolgt dabei derart, dass von einer Strahlungsquelle Strahlung emittiert wird, die über ein Objektiv auf eine Bildebene fokussiert wird, in der sich die Resistschicht befindet. In der Bildebene werden einzelne Substrate mit den darauf aufgebrachten Resistschichten mittels eines Steppers in dem Strahlengang der von der Strahlungsquelle emittierten Strahlen positioniert.

Bei der Belichtung wird die Strahlung durch eine Maske geführt, wobei durch die Struktur der Maske ein bestimmtes Belichtungsmuster vorgebbar ist. Die Maske ist üblicherweise als binäre Maske, beispielsweise in Form einer Chrommaske ausgebildet. Derartige Chrommasken weisen eine alternierende Struktur von transparenten Bereichen, die vorzugsweise von einer Glasschicht gebildet sind, und nicht transparenten Schichten auf, die von den Chromschichten gebildet sind.

Zur Erhöhung des Kontrastes von belichteten und nicht belichteten Bereichen auf der Resistschicht wird anstelle einer Chrommaske eine Phasenmaske verwendet.

Eine derartige Phasenmaske kann insbesondere als Halbton-Phasenmaske ausgebildet sein. Bei derartigen Halbton-Phasenmasken ist die opake Schicht durch eine halbdurchlässige Schicht mit einer Transmission von typischerweise 6% ersetzt, deren Schichtdicken so ausgebildet sind, dass die durchgehende Strahlung einen Phasenhub von 180° erfährt.

Die Druckschrift EP 0 710 890 A1 beschreibt eine Halbtonphasenmaske, die auch für eine Bestrahlung mit Licht im extremultraviolettem Wellenlängenbereich vorgesehen ist und in Transmission arbeitet. Auf einer 600 nm dicken Trägermembran ist eine 262 nm dicke PMMA-Schicht als Phasenschieber und eine 27 nm dicke Germaniumschicht als lichtabschwächende, d.h. teilabsorbierende Schicht angeordnet.

Weiterhin kann die Phasenmaske auch als alternierende Phasenmaske ausgebildet sein. Eine derartige alternierende Phasenmaske weist jeweils von einer Chromschicht getrennte benachbarte transparente Bereiche auf, die jeweils um 180° verschobene Phasen aufweisen. Das heißt, dass die durch einen transparenten Bereich durchgehende Strahlung um 180° phasenversetzt gegenüber der Strahlung ist, die durch den benachbarten transparenten Bereich geführt ist.

Eine alternierende Phasenmaske, die im tief ultravioletten Wellenlängenbereich (DUV, z.B. 248 nm) einsetzbar ist, ist beispielsweise in der Druckschrift Trouiller, Y.; Buffet, N.; Mourier, T.; Schiavone, P.; Quere, Y.: in "0.12 μm Optical Lithography Performances Using an Alternating Deep UV Phase Shift Mask", Jpn. J. Appl. Phys. Vol. 37 (1998), Seiten 6714 - 6717, beschrieben.

Unabhängig von der Wahl der verschiedenen Masken sind die minimalen Strukturbreiten, die mittels bekannter Photolithographieverfahren erzeugbar sind durch die Wellenlänge der vorgegebenen Strahlung begrenzt. Bei bekannten Photolithographieverfahren werden üblicherweise Laser als Strahlungsquellen eingesetzt, deren Wellenlängen vorzugsweise im sichtbaren Bereich liegen. Kleinere Strukturbreiten können dadurch erzeugt werden, in dem beispielsweise Laser verwendet werden, die Strahlung in einem Wellenlängenbereich von etwa 200 nm emittieren. Beispiele für derartige Strahlungsquellen sind Argon Fluorid Laser, die Strahlung bei Wellenlängen von etwa 193 nm emittieren.

Der Erfindung liegt die Aufgabe zugrunde ein Lithographieverfahren sowie eine hierfür geeignete Maske zu schaffen, wodurch die Erzeugung von Strukturen in photoempfindlichen Schichten mit möglichst kleinen Strukturbreiten ermöglicht wird.

Zur Lösung dieser Aufgabe sind die Merkmale der Ansprüche 1 und 4 vorgesehen. Vorteilhafte Ausführungsformen und zweckmäßige weiterbildungen der Erfindung sind in den Unteransprüchen beschrieben.

Bei dem erfindungsgemäßen Lithographieverfahren werden zur Strukturierung von Schichten bei der Herstellung von integrierten Schaltungen photoempfindliche Schichten mit Strahlung belichtet, deren Wellenlänge im Ultraviolettbereich liegt. Auf einer Maske befinden sich mehrere Strukturgrößen, die mit der gleichen Wellenlänge belichtet werden. Die verwendeten Wellenlängen liegen dabei vorzugsweise im Bereich von 11 nm bis 14 nm.

Durch das erfindungsgemäße Verfahren lassen sich die minimalen Strukturbreiten, die auf den photoempfindlichen Schichten erzeugt werden, erheblich verkleinern. Die minimale Strukturbreite, die mittels eines Lithographieverfahrens herstellbar ist, ist durch folgende Beziehung definiert:

$$x = k_1 \cdot \lambda/NA$$

dabei ist $\lambda$ die Wellenlänge der bei der Belichtung verwendeten Strahlung und NA die numerische Apertur des verwendeten Abbildungssystems. Der Faktor $k_1$ ist abhängig von der Ausbildung der jeweils verwendeten Maske. Für binäre Masken liegt der Faktor $k_1$ im Bereich zwischen 0,5 und 0,7. Bei Verwendung einer Halbton-Phasenmaske liegt der Faktor $k_1$ typischerweise im Bereich von 0,38 bis 0,55. Die besten Resultate werden mit alternierenden Phasenmasken erhalten. In diesem Fall liegt der Faktor $k_1$ im Bereich von 0,2 bis 0,38.

Erfindungsgemäß wird zur Belichtung Strahlung im extremen Ultraviolett-Bereich verwendet, dessen Wellenlängen um etwa eine Größenordnung kleiner sind als bei bekannten Photolithographieverfahren. Das optische Abbildungssystem besteht dann vorzugsweise aus Spiegelsystemen. Die dabei verwendeten Aperturen sind zwar deutlich geringer als die bei konventioneller Lichtoptik verwendeten Aperturen, jedoch wird dies durch die Verringerung der Wellenlänge überkompensiert, so dass gegenüber konventionellen Lichtoptiksystemen eine deutlich verbesserte Auflösung erhalten wird.

Die erfindungsgemäße Maske kann sowohl als binäre Maske als auch als Phasenmaske ausgebildet sein, wobei dabei die Phasenmaske als Halbtonphasenmaske oder auch als alternierende Phasenmaske ausgebildet sein kann.

Die erfindungsgemäßen Masken sind dabei jeweils zweckmäßigerweise derart aufgebaut, dass diese eine dünne, transparente Siliziumschicht als Trägerschicht aufweisen. Entsprechend der Ausbildung der Maske als binäre Maske oder Phasenmaske sind auf diese Trägerschicht weitere transparente und/oder opake Schichten aufgebracht. Diese Schichten bestehen vorzugsweise aus Silizium oder Molybdän.

Bei derartigen Masken handelt es sich um Transmissionsmasken. Alternativ können die Masken auch als Reflexionsmasken ausgebildet sein, wobei die Maske in diesem Fall zusätzlich eine nicht transparente, reflektierende Schicht aufweist. Alternativ kann die transparente Trägerschicht durch eine nicht transparente Trägerschicht ersetzt werden.

Die Erfindung wird im nachstehenden anhand der Zeichnungen erläutert. Es zeigen:

Figur 1:    Schematische Darstellung einer Anordnung zur Durchführung des erfindungsgemäßen Lithographieverfahrens.

Figur 2:    Schematische Darstellung einer als binäre Maske ausgebildeten Maske zur Durchführung des erfindungsgemäßen Verfahrens.

Figur 3:    Schematische Darstellung einer als Halbton-Phasenmaske ausgebildeten Maske zur Durchführung des erfindungsgemäßen Verfahrens.

Figur 4:    Schematische Darstellung einer als alternierende Phasenmaske ausgebildeten Maske zur Durchführung des erfindungsgemäßen Verfahrens.

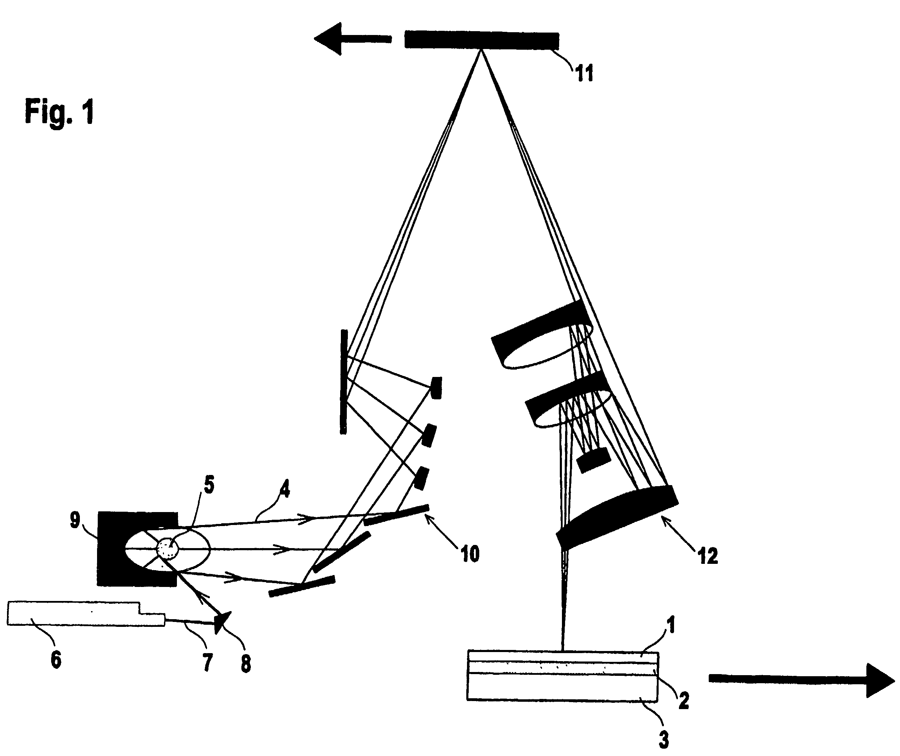

Figur 1 zeigt ein Ausführungsbeispiel einer Anordnung zur Durchführung des erfindungsgemäßen Lithographieverfahrens zur Belichtung einer photoempfindlichen Schicht. Derartige Prozesse finden bei der Herstellung von integrierten Schaltungen Anwendung.

Die photoempfindliche Schicht ist insbesondere als Resistschicht 1 ausgebildet. Diese Resistschicht 1 ist beispielsweise auf einer Isolatorschicht 2 aufgebracht, die unmittelbar oder unter Zwischenlagerung einer Metallschicht auf einem Substrat 3 aufsitzt, welches integrierte Schaltungen enthält. Dieses Substrat 3 besteht vorzugsweise aus Silizium. Die Isolatorschicht 2 besteht vorzugsweise aus einem Siliziumoxid. In diese Isolatorschicht 2 werden Leitbahnen eingearbeitet, wobei zur Herstellung der Leitbahnen nach einem vorgegebenen Muster Gräben und Kontaktlöcher eingeätzt werden, in welche anschließend Metall abgeschieden wird.

Die Gräben und Kontaktlöcher werden mittels eines Ätzprozesses, vorzugsweise mittels eines Plasma-Ätzprozesses in die Isolatorschicht 2 eingearbeitet. Hierzu wird aus der auf der Isolatorschicht 2 aufliegenden Resistschicht 1 wenigstens eine Resistmaske hergestellt, die ein den Gräben und Kontaktlöchern entsprechendes Lochmuster aufweist. Die Einarbeitung von Gräben und Kontaktlöchern erfolgt durch ein Ätzen durch die Löcher der Resistmaske.

Die Herstellung der Resistmaske aus der Resistschicht 1 erfolgt mittels des erfindungsgemäßen Lithographieverfahrens. Die Resistschicht 1 wird hierzu an vorgegebenen Schichten belichtet und danach entwickelt. Je nachdem ob es sich bei der Resistschicht 1 um einen Positiv- oder Negativ-Resist handelt, werden bei der Entwicklung die belichteten oder unbelichteten Bereiche der Resistschicht 1 entfernt.

Zur Durchführung des Belichtungsprozesses ist eine Strahlung 4 emittierende Strahlungsquelle 5 vorgesehen.

Die Strahlungsquelle 5 ist im vorliegenden Fall von einer Xenon-Plasma-Quelle gebildet, die Strahlung 4 im extremen Ultraviolettbereich emittiert. Die Wellenlänge $\lambda$ der emittierten Strahlung 4 liegt im Bereich 11 nm $\leq \lambda \leq$ 14 nm.

Die Strahlungsquelle 5 wird über einen NdYAG Laser 6 optisch angeregt. Hierzu sind die vom NdYAG Laser 6 emittierten Laserlichtstrahlen 7 über ein Prisma 8 zur Strahlungsquelle 5 geführt.

Die Strahlungsquelle 5 befindet sich im Brennpunkt eines Parabolspiegels 9. Die am Parabolspiegel 9 reflektierte Strahlung 4 wird über ein erstes Spiegelsystem 10 geführt. Dadurch wird die Strahlung 4 auf eine Maske 11 fokussiert, die im vorliegenden Fall als Reflexionsmaske ausgeführt ist.

Die an der Maske 11 reflektierte Strahlung 4 wird über ein zweites Spiegelsystem 12, welches aus asphärischen Spiegeln besteht, auf die zu belichtende Resistschicht 1 geführt. Entsprechend dem Muster der Maske 11 wird dann ein Belichtungsmuster auf der Resistschicht 1 erzeugt. Hierzu werden die Maske 11 und die Resistschicht mittels eines nicht dargestellten Stepper-Systems quer zur Strahlachse der Strahlung 4 in geeigneter Form ausgelenkt.

Mit dem in Figur 1 dargestellten Ausführungsbeispiel wird eine numerische Apertur erhalten, die typischerweise etwa NA = 0,1 beträgt.

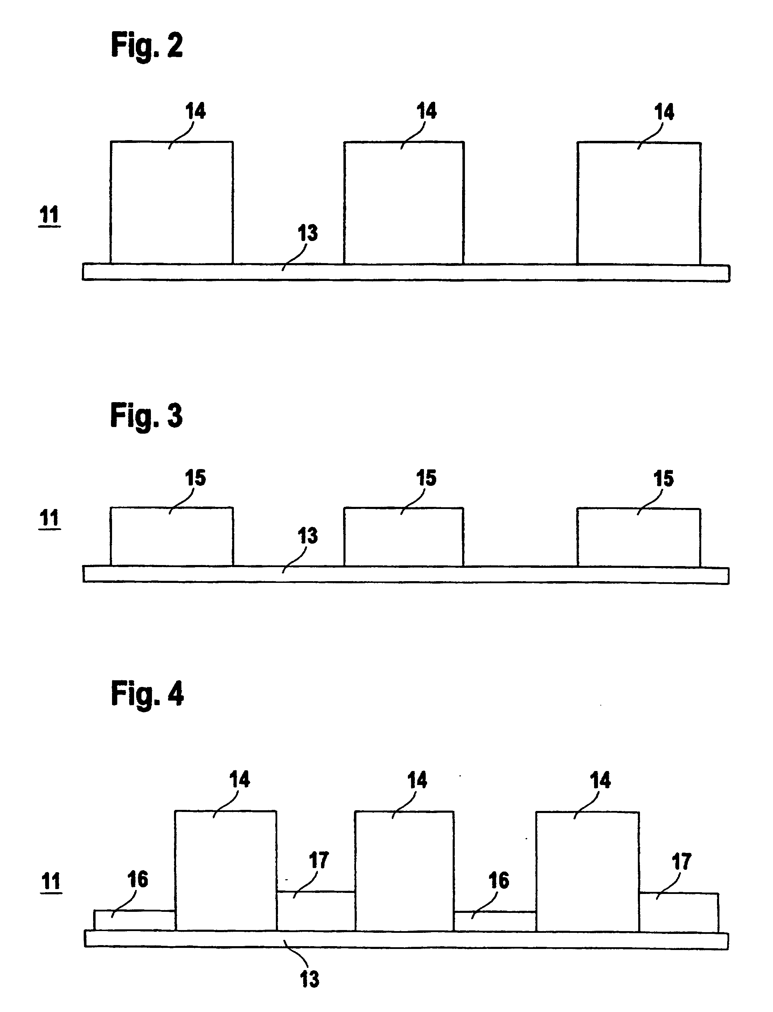

Die Maske 11 weist Strukturen von transparenten und/oder opaken Zonen auf, deren Strukturgrößen an die Wellenlängen der verwendeten Strahlung 4 angepasst sind. Während die Maske 11 gemäß Figur 1 als Reflexionsmaske ausgebildet ist, sind die in den Figuren 2 bis 4 dargestellten Masken 11 als Transmissionsmasken ausgebildet.

Diese Masken 11 bestehen jeweils aus einer Anordnung verschiedener Schichten aus Silizium und/ oder Molybdän. Die Schichtdicken der einzelnen Schichten sind dabei so dimensioniert, dass eine vorgegebene Absorption und Phasenverschiebung der diese Schichten durchsetzende Strahlung 4 erhalten wird.

Die Absorption bei Durchgang der Strahlung 4 durch eine Schicht mit einer Schichtdicke d berechnet sich dabei nach folgender Beziehung:

$$I = I_0 \exp(-2\,\alpha \cdot d)$$

wobei $I_0$ die Intensität der einfallenden Strahlung 4 und I die Intensität der Strahlung bei Austritt aus der Schicht ist. Schließlich ist $\alpha$ der Absorptionskoeffizient der betreffenden Schicht.

Die Phasenverschiebung $\Delta\varphi$ der eine Schicht der Schichtdicke d durchsetzenden Strahlung 4 berechnet sich nach folgender Beziehung:

$$\Delta\varphi = 360° \, (n-1)\, d/\lambda$$

wobei n der Brechungsindex der jeweiligen Schicht ist.

Die Materialkonstanten für Silizium und Molybdän sind hierbei

$$n_{Mo} = 1 + 7 \cdot 10^{-2}\,, \quad \alpha_{Mo} = 2,9 \cdot 10^{-3}\,/nm$$

$$n_{Si} = 1,0 \qquad , \quad \alpha_{Si} = 0,87 \cdot 10^{-3}\,/nm$$

Daraus ergibt sich insbesondere, dass Strahlung 4, die durch eine Molybdänschicht geführt ist, eine Phasenverschiebung erfährt, nicht jedoch eine durch eine Siliziumschicht geführte Strahlung 4.

Figur 2 zeigt schematisch ein erstes Ausführungsbeispiel der erfindungsgemäßen Maske 11. Diese Maske 11 ist als binäre Maske ausgebildet. Die Maske 11 weist eine dünne, transparente Trägerschicht 13 auf. Diese Trägerschicht 13 besteht aus einer Siliziumschicht mit einer Schichtdicke von 100 nm. Auf die Trägerschicht 13 sind entsprechend dem zu erzeugenden Belichtungsmuster opake Bereiche 14 aufgebracht. Diese opaken Bereiche 14 bestehen ebenfalls aus Siliziumschichten, die jedoch erheblich größere Schichtdicken als die Trägerschicht 13 aufweisen.

Im vorliegenden Ausführungsbeispiel beträgt die Schichtdicke der die opaken Bereiche 14 bildenden Siliziumschichten 2,6 $\mu$m. Bei der so ausgebildeten binären Maske 11 beträgt der Intensitätsverlust der Strahlung 4 bei Durchgang durch die transparente Trägerschicht 13 etwa 20 % und bei Durchgang durch die opaken Bereiche 14 etwa 99 %.

Figur 3 zeigt ein weiteres Ausführungsbeispiel der erfindungsgemäßen Maske 11. Die Maske 11 ist als Halbtonmaske ausgebildet und weist wiederum eine transparente Trägerschicht 13 auf, die von einer Siliziumschicht mit einer Schichtdicke von 100 nm gebildet ist. Entsprechend dem zu erzeugenden Belichtungsmuster sind auf der Trägerschicht 13 phasenschiebende, teiltransparente Bereiche 15 aufgebracht. Die phasenschiebenden, teiltransparenten Bereiche 15 sind von Molybdänschichten mit einer Schichtdicke von 455 nm gebildet. Die Schichtdicke der Molybdänschicht ist dabei so gewählt, dass für die diese Schicht durchsetzende Strahlung 4 eine Phasenverschiebung von 180° erhalten wird.

Die Trägerschicht 13 weist eine Transmission von etwa 80 % auf. Bei den phasenschiebenden, teiltransparenten Bereichen 15 beträgt der Intensitätsverlust der diese Bereiche 15 durchsetzenden Strahlung 4 etwa 94 %.

Bei dem in Figur 4 dargestellten Ausführungsbeispiel ist die erfindungsgemäße Maske 11 als alternierende Phasenmaske ausgebildet. Wiederum weist die Phasenmaske eine transparente Trägerschicht 13 auf, die von einer Siliziumschicht mit einer Schichtdicke von 100 nm gebildet ist. Auf der Trägerschicht 13 sind alternierend erste und zweite transparente Bereiche 16, 17 aufgebracht, welche durch opake Bereiche 14 getrennt sind. Dabei weist die einen ersten transparenten Bereich 16 durchsetzende Strahlung 4 eine um 180° verschobene Phase bezüglich der einen zweiten transparenten Bereich 17 durchsetzenden Strahlung 4 auf.

Die ersten transparenten Bereiche 16 sind jeweils von einer Molybdänschicht mit einer Schichtdicke von 93 nm gebildet. Die zweiten transparenten Bereiche 17 sind jeweils von einer Siliziumschicht mit einer Schichtdicke von 315 nm gebildet. Durch diese Wahl der Schichtdicken wird erreicht, dass die einen ersten und zweiten transparenten Bereich 16, 17 durchsetzende Strahlung 4 jeweils gleich geschwächt wird. Im vorliegenden Fall beträgt die Transmission für die ersten und zweiten transparenten Bereiche 16, 17 jeweils etwa 58 % der Intensität der einfallenden Strahlung 4. Bei Durchgang durch einen von der Molybdänschicht gebildeten ersten transparenten Bereich 16 erfährt die Strahlung 4 eine Phasenverschiebung von 180°. Demgegenüber bleibt die Phase der Strahlung 4 bei Durchgang durch einen von einer Siliziumschicht gebildeten zweiten transparenten Bereich 17 unverändert.

Die opaken Bereiche 14 der alternierenden Phasenmaske sind von Siliziumschichten mit einer Schichtdicke von jeweils 2,6 µm gebildet. Die opaken Bereiche 14 sind somit entsprechend der binären Maske 11 gemäß Figur 2 ausgebildet.

Bezugszeichenliste

| | |
|---|---|
| 1 | Resistschicht |
| 2 | Isolatorschicht |
| 3 | Substrat |
| 4 | Strahlung |
| 5 | Strahlungsquelle |
| 6 | NdYAG Laser |
| 7 | Laserlichtstrahlen |
| 8 | Prisma |
| 9 | Parabolspiegel |
| 10 | Spiegelsystem |
| 11 | Maske |
| 12 | Spiegelsystem |
| 13 | Trägerschicht |
| 14 | opake Bereiche |
| 15 | teiltransparente Bereiche |
| 16 | erster transparenter Bereich |
| 17 | zweiter transparenter Bereich |

**Patentansprüche**

**1.** Maske zur Strukturierung von Schichten bei der Herstellung von integrierten Schaltungen,

- wobei zur Belichtung von photoempfindlichen Schichten die von einer Strahlungsquelle (5) emittierte, im extremen Ultraviolettbereich liegende Strahlung (4) über die als Halbton-Phasenmaske ausgebildete Maske (11) in Transmission auf die photoempfindlichen Schichten geführt wird,

- wobei die Maske aus mehreren Schichten mit darin angeordneten Strukturen aufgebaut ist, deren Breiten an die Wellenlängen der von der Strahlungsquelle (5) emittierten, im extremen Ultraviolettbereich liegenden Strahlung (4) angepasst sind,

**dadurch gekennzeichnet, dass** die Maske eine transparente Trägerschicht (13) aufweist, die von einer Siliziumschicht gebildet ist, wobei auf der Trägerschicht (13) phasenschiebende, teiltransparente Bereiche (15, 16) bildende Molybdänschichten in Abstand zueinander aufgebracht sind.

**2.** Maske nach Anspruch 1,
**dadurch gekennzeichnet, dass**
die Schichtdicke der Siliziumschicht etwa 100 nm beträgt, und dass die Schichtdicke der Molybdänschicht etwa 455 nm beträgt.

**3.** Maske nach Anspruch 2,
**dadurch gekennzeichnet, dass**

bei Durchgang der Strahlung (4) durch die Molybdänschicht deren Phase um 180° verschoben wird.

**4.** Maske zur Strukturierung von Schichten bei der Herstellung von integrierten Schaltungen,

- wobei zur Belichtung von photoempfindlichen Schichten die von einer Strahlungsquelle (5) emittierte, im extremen Ultraviolettbereich liegende Strahlung (4) über die Maske (11) in Transmission auf die photoempfindlichen Schichten geführt wird,
- wobei die Maske aus mehreren Schichten mit darin angeordneten Strukturen aufgebaut ist, deren Breiten an die Wellenlängen der von der Strahlungsquelle (5) emittierten, im extremen Ultraviolettbereich liegenden Strahlung (4) angepasst sind,

**dadurch gekennzeichnet, dass**

a) die Maske (11) eine alternierende Phasenmaske ist und eine transparente Trägerschicht (13) aufweist, die von einer Siliziumschicht gebildet ist, wobei
b) auf der Trägerschicht (13) alternierend und durch opake Bereiche (14) getrennt erste und zweite transparente Bereiche (16, 17) aufgebracht sind, wobei
c) die einen der ersten transparenten Bereiche (16) durchsetzende Strahlung (4) eine um 180° verschobene Phase bezüglich der einen der zweiten transparenten Bereiche (17) durchsetzenden Strahlung (4) aufweist, wobei
d) die ersten transparenten Bereiche (16) von Molybdänschichten mit einer Schichtdicke von etwa 93 nm gebildet sind.

**5.** Maske nach Anspruch 4,
**dadurch gekennzeichnet, dass**
die zweiten transparenten Bereiche (17) von ersten weiteren Siliziumschichten mit einer Schichtdicke von etwa 315 nm gebildet sind.

**6.** Maske nach einem der Ansprüche 4 oder 5,
**dadurch gekennzeichnet, dass**
die opaken Bereiche (14) von zweiten weiteren Siliziumschichten mit einer Schichtdicke von etwa 2,6 μm gebildet sind.

**7.** Verwendung einer Maske nach einem der Ansprüche 1 - 6 zur Belichtung einer photoempfindlichen Schicht mittels einer Strahlungsquelle (5), die Strahlung (4) im Wellenlängenbereich 11 nm ≤ λ ≤ 14 nm emittiert.

**Claims**

**1.** Mask for patterning layers during the fabrication of integrated circuits,

- for the exposure of photosensitive layers, the radiation (4) which is emitted by a radiation source (5) and lies in the extreme ultraviolet region being guided via the mask (11), which is formed as a halftone phase mask, in transmission onto the photosensitive layers,
- the mask being constructed from a plurality of layers with structures arranged therein, the widths of which are adapted to the wavelengths of the radiation (4) which is emitted by the radiation source (5) and lies in the extreme ultraviolet region,

**characterized in that**
the mask has a transparent carrier layer (13) formed by a silicon layer, molybdenum layers forming phase-shifting, semitransparent regions (15, 16) being applied at a distance from one another on the carrier layer (13).

**2.** Mask according to Claim 1,
**characterized in that**
the layer thickness of the silicon layer is about 100 nm, and **in that** the layer thickness of the molybdenum layer is about 455 nm.

**3.** Mask according to Claim 2,
**characterized in that**
when the radiation (4) passes through the molybdenum layer, its phase is shifted by 180°.

**4.** Mask for patterning layers during the fabrication of integrated circuits,

- for the exposure of photosensitive layers, the radiation (4) which is emitted by a radiation source (5) and lies in the extreme ultraviolet region being guided via the mask (11) in transmission onto the photosensitive layers,
- the mask being constructed from a plurality of layers with structures arranged therein, the widths of which are adapted to the wavelengths of the radiation (4) which is emitted by the radiation source (5) and lies in the extreme ultraviolet region,

**characterized in that**

a) the mask (11) is an alternating phase mask and has a transparent carrier layer (13) formed by a silicon layer,
b) first and second transparent regions (16, 17) being applied on the carrier layer (13) alternately and in a manner separated by opaque regions (14),

c) the radiation (4) which penetrates through one of the first transparent regions (16) having a phase shifted by 180° relative to the radiation (4) which penetrates through one of the second transparent regions (17),

d) the first transparent regions (16) being formed by molybdenum layers having a layer thickness of about 93 nm.

5. Mask according to Claim 4,
   **characterized in that**
   the second transparent regions (17) are formed by first further silicon layers having a layer thickness of about 315 nm.

6. Mask according to either of Claims 4 and 5,
   **characterized in that**
   the opaque regions (14) are formed by second further silicon layers having a layer thickness of about 2.6 µm.

7. Use of a mask according to one of Claims 1-6 for the exposure of a photosensitive layer by means of a radiation source (5) which emits radiation (4) in the wavelength range of 11 nm $\leq \lambda \leq$ 14 nm.

**Revendications**

1. Masque de structuration de couches dans la fabrication de circuits intégrés

   - dans lequel pour l'exposition de couches photosensibles, on fait passer le rayonnement (4) émis par une source (5) de rayonnement et se trouvant dans le domaine de l'utraviolet lointain à travers le masque (11) constitué en masque à phase demi-ton en transmission sur les couches photosensibles,
   - dans lequel le masque est constitué de plusieurs couches ayant des structures en leur sein dont les largeurs sont adaptées aux longueurs d'ondes du rayonnement (4) émis par la source (5) de rayonnement et se trouvant dans le domaine de l'ultraviolet lointain,

     **caractérisé en ce que**

   le masque a une couche (13) support transparente qui est formée d'une couche de silicium, des couches de molybdène formant des parties (15, 16) semi-transparentes de déphasage étant disposées à distance les unes des autres sur la couche (13) support.

2. Masque suivant la revendication 1,
   **caractérisé en ce que**

l'épaisseur de la couche de silicium est d'environ 100 nm et l'épaisseur de la couche de molybdène est d'environ 455 nm.

3. Masque suivant la revendication 2,
   **caractérisé en ce que**, lors du passage du rayonnement (4) à travers la couche de molybdène, sa phase est tournée de 180°.

4. Masque de structuration de couches dans la fabrication de circuits intégrés,

   - dans lequel, pour l'exposition de couches photosensibles, le rayonnement émis par une source (5) de rayonnement et se trouvant dans le domaine de l'utraviolet lointain passe à travers le masque (11) en transmission sur les couches photosensibles,
   - dans lequel le masque est constitué de plusieurs couches ayant des structures en leur sein dont les largeurs sont adaptées aux longueurs d'ondes du rayonnement (4) émis par la source (5) de rayonnement et se trouvant dans le domaine de l'ultraviolet lointain,

     **caractérisé en ce que**

   a) le masque (11) est un masque de phase alternée et a une couche (13) support transparente qui est formée par une couche de silicium, dans lequel

   b) sur la couche (13) support sont déposées, en alternance et séparées par des parties (14) opaques, des premières et deuxièmes parties (16, 17) transparentes, dans lequel

   c) le rayonnement (4) passant à travers l'une des premières parties (16) transparentes est déphasée de 180° par rapport au rayonnement (4) passant à travers l'une des deuxièmes parties (17) transparentes,
      dans lequel

   d) les premières parties (16) transparentes sont formées de couches de molybdène d'une épaisseur d'environ 93 nm.

5. Masque suivant la revendication 4,
   **caractérisé en ce que** les deuxièmes parties (17) transparentes sont formées d'autres premières couches de silicium d'une épaisseur d'environ 315 nm.

6. Masque suivant l'une des revendications 4 ou 5,
   **caractérisé en ce que**
   les parties (14) opaques sont formées d'autres deuxièmes couches de silicium d'une épaisseur d'environ 2,6 µm.

7. Utilisation d'un masque suivant l'une des revendications 1 à 6, pour l'exposition d'une couche photosensible au moyen d'une source (5) de rayonnement, qui émet du rayonnement (4) dans le domaine des longueurs d'ondes 11 nm $\leq \lambda \leq$ 14 nm.

**Fig. 1**

EP 1 117 001 B1

## Fig. 2

## Fig. 3

## Fig. 4